**Europäisches Patentamt**

**European Patent Office**

**Office européen des brevets**

(19)

(11) Numéro de publication: **0 133 084**
**B1**

(12) **FASCICULE DE BREVET EUROPEEN**

(45) Date de publication du fascicule du brevet:
03.06.87

(21) Numéro de dépôt: **84401420.9**

(22) Date de dépôt: **04.07.84**

(51) Int. Cl.⁴: **C 30 B 29/32,** C 30 B 15/10,
C 30 B 11/00, C 30 B 13/14

(54) **Procédé de fabrication de monocristaux de germanate de bismuth à fort rendement de scintillation.**

(30) Priorité: **07.07.83 FR 8311349**

(43) Date de publication de la demande:
**13.02.85 Bulletin 85/7**

(45) Mention de la délivrance du brevet:
**03.06.87 Bulletin 87/23**

(84) Etats contractants désignés:
**DE GB NL**

(56) Documents cités:
**GB - A - 2 039 868**
**GB - A - 2 115 310**
**US - A - 4 055 391**

**IBM TECHNICAL DISCLOSURE BULLETIN, vol. 15, no. 5,**
**octobre 1972, page 1520, New York, US; P.S. YIN et al.:**
**"Employment of neutral ambient gas in iridium**
**crucibles"**

(73) Titulaire: **COMMISSARIAT A L'ENERGIE ATOMIQUE**
**Etablissement de Caractère Scientifique Technique et**
**Industriel, 31/33, rue de la Fédération, F-75015 Paris**
**(FR)**

(72) Inventeur: **Le Gal, Hervé, 40, rue Jean Jacques**
**Rousseau, F-38400 Saint Martin d'Heres (FR)**
Inventeur: **Damelet, Jean-Louis, Hameau de L'Aragna,**
**F-38560 Jarrie (FR)**

(74) Mandataire: **Mongrédien, André et al, c/o**
**BREVATOME 25, rue de Ponthieu, F-75008 Paris (FR)**

## Description

La présente invention concerne un procédé de fabrication de monocristaux de germanate de bismuth à fort rendement de scintillation.

Elle s'applique, en particulier, au domaine de la fabrication de scintillateurs utilisés comme détecteurs de rayonnement à haute énergie en médecine (tomodensitomètres, caméra à positrons), en physique des hautes énergies et dans la recherche pétrolière et minière, par exemple.

Certaines de ces applications nécessitent des cristaux de dimensions importantes (diamètre >50 mm, longueur >200 mm) et, dans tous les cas, on a besoin du meilleur rendement lumineux possible.

Pour cela il faut éviter les impuretés qui peuvent diminuer l'intensité de l'émission lumineuse ainsi que tout ce que est susceptible de la réabsorber pendant son trajet à l'intérieur du matériau (impuretés, précipités, inclusions diverses...).

La méthode de fabrication de monocristaux de germanate de bismuth (couramment nommé BGO) la plus utilisée est la méthode Czochralski, une méthode de tirage qui consiste à porter à la température de fusion ($T_F$ = 1050 °C), dans un creuset approprié, une charge polycristalline voisine de la composition désirée, puis à mettre en contact avec ce bain fondu un petit barreau monocristallin convenablement taillé et orienté appelé germe. A partir de cet instant, une translation lente de ce germe (quelques mm/h) ainsi qu'un asservissement de la température du creuset permettent la croissance d'un monocristal ayant la géométrie désirée à condition d'avoir un environnement thermique convenable et une atmosphère satisfaisante.

A l'heure actuelle, on fabrique des monocristaux de BGO à partir de creusets en platine et sous atmosphère oxydante.

Un tel procédé de fabrication des monocristaux de BGO selon l'art antérieur est décrit dans la publication de O.H. Nestor et C.Y. Huang (Harshaw Cie) dans IEEE Transactions on Nuclear Science, V45, 22 (fev. 1975). Le procédé selon cette publication permet d'obtenir des monocristaux de grandes dimensions qui présentent effectivement les propriétés de scintillation. Néanmoins, ces cristaux présentent tous des nappes de défauts macroscopiques (bulles, inclusions, filaments, etc.) qui diffusent la lumière, amoindrissent le rendement global de scintillation, et nuisent à l'homogénéité de la réponse lumineuse le long du lingot.

Il est bien connu des métallurgistes que l'alliage Pt-Bi se forme à 730 °C. La température de fusion du BGO est égale à 1050 °C: ceci impose d'utiliser les creusets en platine sous atmosphère oxydante pour éviter la présence de bismuth métal. Malgré cela, on observe une corrosion du creuset avec l'accumulation d'impuretés métalliques issues du platine à l'intérieur des inclusions bulleuses du cristal.

Les publications scientifiques sont nombreuses qui décrivent tous les défauts des monocristaux fabriqués selon ce procédé de l'art antérieur et la façon d'en réduire la quantité (par exemple K. Takagi, T. Fukazawa, M. Ishii, S. Akiyama (Hitachi), J. of Cristal Growth, 52 (1981), p. 584–587.

Ces méthodes pour améliorer la qualité des cristaux de BGO, comme l'utilisation de matières premières pures, la croissance des cristaux à une vitesse lente, les cristallisations successives, la rotation importante du cristal, sont onéreuses et longues à réaliser et, dans ce cas précis, d'une efficacité médiocre.

L'invention a justement pour but de remédier à ces inconvénients et notamment de permettre l'élaboration de monocristaux de BGO de toutes dimensions exempts de centres diffuseurs de lumière.

De façon plus précise, l'invention a pour objet un procédé de fabrication de monocristaux de germanate de bismuth à fort rendement de scintillation basé sur la croissance d'un monocristal à partir d'un bain fondu dans un creuset ou un récipient, caractérisé en ce que le récipient est en iridium, et en ce que la fusion et la croissance sont effectuées sous une atmosphère neutre ou faiblement oxydante.

Selon une autre caractéristique de ce procédé, la pression partielle d'oxygène est inférieure ou égale à 1%.

L'utilisation de creusets en iridium pour la croissance de cristaux n'est pas nouvelle. Par exemple, l'article de P.S. Yin, S.E. Blum, P. Chaudhari et D.F. O'Kane paru dans IBM Technical Disclosure Bulletin, vol. 15, n° 5, octobre 1972 indique l'utilisation de creusets en iridium pour réaliser des cristaux d'oxydes à point de fusion élevé, tels que des silicates. Cet article précise que les creusets subissent une corrosion importante et que le matériau à élaborer risque d'être contaminé par l'iridium: pour remédier à ces inconvénients, on propose de travailler sous atmosphère neutre, par exemple dans une atmosphère d'argon.

D'autre part, le document US-A-4055391 décrit lui aussi, dans son introduction, les défauts des creusets en iridium: ce matériau doit être utilisé à des températures voisines de 1200 °C et subit une corrosion importante. Il faut donc remplacer souvent les creusets, ce qui est très coûteux.

Or, contrairement à ce qui est enseigné dans ces documents, les inventeurs ont montré que, dans le cas particulier du germanate de bismuth, on obtenait de très bons résultats en travaillant à des températures inférieures à 1200 °C (de l'ordre de 1100 °C ou éventuellement moins) et en atmosphère légèrement oxydante. La température de fusion du BGO étant de 1050 °C, on peut travailler à des températures de l'ordre de 1100 °C et éviter les réactions entre le bismuth et l'iridium qui se produisent au-delà de 1400 °C. De plus, on a constaté que, si la pression partielle d'oxygène était inférieure à 1%, on ne décelait que très peu d'inclusions d'iridium dans les cristaux. Cependant, avec des pressions partielles d'oxygène légèrement supérieures, la quantité d'iridium dans les cristaux est plus importante mais peut rester dans

3   **0133084**   4

les limites acceptables suivant l'utilisation envisagée.

Selon un mode préféré de mise en oeuvre du procédé de l'invention, la croissance du monocristal est effectuée selon la méthode de Czochralski.

Selon un autre mode de mise en oeuvre du procédé de l'invention, la croissance du monocristal est effectuée selon la méthode de la zone fondue.

Selon un autre mode de mise en oeuvre du procédé de l'invention, la croissance du monocristal est effectuée selon la méthode Bridgmann en géométrie verticale ou horizontale.

Selon une autre caractéristique du procédé de l'invention, lorsqu'une coloration apparaît sur le lingot élaboré, un recuit de l'ordre de quelques heures à l'air est effectué afin de rendre le monocristal incolore.

D'autres caractéristiques et avantages de l'invention ressortiront mieux de la description qui va suivre, donné à titre illustratif mais non limitatif.

On a réalisé une campagne de tirage de monocristaux de BGO selon la méthode de Czochralski ayant pour but de comparer les effets des paramètres suivants:
- creuset platine et atmosphère oxydante,
- creuset iridium et atmosphère faiblement oxydante ($Po_2 \leq 10^{-3}$ torr).

Les autres paramètres de la croissance étaient identiques et on a mis en évidence que l'iridium a un comportement chimique beaucoup plus neutre que le platine vis-à-vis du germanate de bismuth en fusion. Les creusets en iridium et les conditions de tirage n'introduisent pas de cause de pollution majeure, contrairement au platine.

On a observé que l'atmosphère oxydante nécessaire pour l'utilisation d'un creuset en platine favorise fortement l'évaporation de l'oxyde de bismuth alors que, sous atmosphère neutre ou faiblement oxydante, une évaporation congruente du bain intervient; par analogie, la composition à fusion congruente va se rapprocher de la composition stoechiométrique et donc réduire la surfusion constitutionnelle au voisinage de l'interface de croissance du cristal.

Les cristaux élaborés à partir de creusets en iridium et sous atmosphère neutre ou faiblement oxydante sont parfaitement clairs et transparents et exempts d'inclusions macroscopiques (bulles, filaments...) telles qu'on en observe systématiquement dans les lingots tirés sous atmosphère oxydante à partir d'un creuset en platine. Leurs propriétés de scintillation ne peuvent donc qu'en être améliorées.

En outre, la vitesse de cristallisation peut être augmentée sensiblement dans des conditions équivalentes (d'un facteur 2 dans l'exemple précédent mais ce résultat n'est pas limitatif).

Lorsqu'une coloration apparaît sur le lingot élaboré dans ces conditions, un simple recuit de quelques heures à l'air suffit à le rendre incolore; il est par contre impossible d'éliminer par recuit le type de défaut obtenu dans les conditions classiques.

Enfin, on a pu constater qu'il y avait très peu de corrosion du creuset en iridium puisqu'on a pu réaliser plusieurs dizaines d'essais sans perte significative du métal: ceci représente un gros avantage car l'iridium est un élément très coûteux et la corrosion entraîne la nécessité de changer souvent les creusets.

Le procédé de fabrication de monocristaux de BGO selon l'invention est applicable dans toutes les méthodes de croissance de monocristaux à partir d'un bain fondu, parmi lesquelles on cite comme un mode préférentiel la méthode de Crochzalski. Mais la méthode de la zone fondue, la méthode Bridgmann en géométrie verticale ou horizontale ou des méthodes analogues sont aussi envisageables.

Enfin, il est facile de reconnaître les cristaux réalisés par le procédé de l'invention grâce à leur teneur en iridium. Une méthode d'analyse globale (permettant d'analyser des échantillons d'un volume de 2 à 3 $cm^3$) ont montré que des cristaux de BGO réalisés selon l'invention contenaient 7 ppm de platine et 200 ppm d'iridium, ces teneurs étant de 150 ppm et 20 ppm pour des cristaux réalisés dans des creusets en platine.

**Revendications**

1. Procédé de fabrication de monocristaux de germanate de bismuth à fort rendement de scintillation basé sur la croissance d'un monocristal à partir d'un bain fondu dans un creuset ou récipient, caractérisé en ce que le récipient est en iridium et en ce que la fusion et la croissance sont effectuées sous une atmosphère neutre ou faiblement oxydante.

2. Procédé selon la revendication 1, caractérisé en ce que la pression partielle d'oxygène dans l'atmosphère est inférieure ou égale à 1 %.

3. Procédé selon l'une quelconque des revendications 1 et 2, caractérisé en ce que la croissance du monocristal est effectuée selon la méthode de Czochralski.

4. Procédé selon l'une quelconque des revendications 1 et 2, caractérisé en ce que la croissance du monocristal est effectuée selon la méthode de la zone fondue.

5. Procédé selon l'une quelconque des revendications 1 et 2, caractérisé en ce que la croissance du monocristal est effectuée selon la méthode Bridgmann en géométrie verticale ou horizontale.

6. Procédé selon l'une quelconque des revendications 1 à 5, caractérisé en ce que, lorsqu'une coloration apparaît sur le lingot élaboré, un recuit de l'ordre de quelques heures à l'air est effectué afin de rendre le monocristal incolore.

**Patentansprüche**

1. Verfahren zur Herstellung von Wismutgermanat-Einkristallen mit hoher Scintillationsausbeute, wobei das Verfahren auf dem Wachsen eines Einkristalls aus einem Schmelzbad in einem Schmelztiegel oder -behälter beruht, dadurch gekennzeichnet, dass der Behälter aus Iridium besteht und dass das Schmelzen und das Wachsen in einer neutralen oder schwach oxidierenden Atmosphäre durchgeführt werden.

2. Verfahren nach Anspruch 1, dadurch gekennzeichnet, dass der Sauerstoffpartialdruck in der Atmosphäre kleiner oder gleich 1% ist.

3. Verfahren nach Anspruch 1 oder 2, dadurch gekennzeichnet, dass das Wachsen des Einkristalls nach dem Czochralski-Verfahren durchgeführt wird.

4. Verfahren nach Anspruch 1 oder 2, dadurch gekennzeichnet, dass das Wachsen des Einkristalls nach dem Schmelzzonenverfahren durchgeführt wird.

5. Verfahren nach Anspruch 1 oder 2, dadurch gekennzeichnet, dass das Wachsen des Einkristalls nach dem Bridgmann-Verfahren mit vertikaler oder horizontaler Geometrie durchgeführt wird.

6. Verfahren nach einem der Ansprüche 1 bis 5, dadurch gekennzeichnet, dass man beim Auftreten einer Färbung bei dem hergestellten Block diesen in der Grössenordnung von einigen Stunden in Luft wieder glüht, um den Einkristall farblos zu machen.

**Claims**

1. Process for the manufacture of bismuth germanate single crystals with a high scintillation yield, based on the growth of a single crystal from a molten bath in a crucible or receptacle, characterized in that the receptacle is made of iridium and in that the melting and the growth are performed under a neutral or weakly oxidizing atmosphere.

2. Process according to claim 1, characterized in that the partial pressure of oxygen in the atmosphere is below or equal to 1%.

3. Process according to either of claims 1 and 2, characterized in that the growth of the single crystal is performed using the Czochralski method.

4. Process according to either of claims 1 and 2, characterized in that the growth of the single crystal is performed using the zone melting method.

5. Process according to either of claims 1 and 2, characterized in that the growth of the single crystal is performed using the Bridgmann method in vertical or horizontal geometry.

6. Process according to any one of claims 1 to 5, characterized in that, when a colour appears on the ingot produced, an annealing of the order of several hours in air is performed in order to make the single crystal colourless.